# EUROPEAN PATENT APPLICATION

(11) **EP 4 803 912 A1**
(43) Date of publication of application: **09.09.2026**
(21) Application number: 26159549.0
(22) Date of filing: 19.02.2026
(51) Int. Cl.: G01R 31/26, G01R 19/00, G01R 27/14, H02M 1/00

(54) **A METHOD AND CIRCUIT ARRANGEMENT FOR DETERMINING A RESISTANCE**

(30) Priority: 04.03.2025 US 202519070176
(71) Applicant: Analog Devices International Unlimited Company, Limerick (IE)
(72) Inventor: DWERSTEG, Bernhard Karl-Heinz, Co. Limerick (IE)
(74) Representative: Yang, Shu

(57) **Abstract**

A new method and circuit arrangement for determining a resistance of a first transistor in a drive system for operating a motor. The drive system comprising a plurality of transistors, and each transistor of the plurality of transistors comprising a control terminal, a first channel terminal, and a second channel terminal. The plurality of transistors is switched to operate the motor using an operating current. A test current is applied between the first and second channel terminals of the first transistor during the on-state of each of the plurality of transistors. The test current is a current value. A voltage difference is measured between the first and second channel terminals of the first transistor during the application of the test current. The on-state resistance of the first transistor is determined based on the current value and the measured voltage difference.

## Description

### FIELD

This application relates to methods and circuit arrangements for determining a resistance of a first transistor. Specifically, for determining a resistance of a first transistor in a motor drive system during the operation of a motor.

### BACKGROUND

It is generally known that in BLDC / PMSM motor drives using the FOC control scheme (with sensors, or sensorless), allows highest efficiency by applying a sine wave shaped current waveform to the stator fitting to the actual state the motor is in. Similar requirements are used for operating stepper motors. Even small BLDC/PMSM motors, for example, those in power tools often need higher drive current than directly possible from a smart-power IC. Therefore a 6 MOSFET inverter stage is standard in many applications, including BLDC / PMSM motor drives (or a 4 or 8 MOSFET inverter in the case of a stepper motor). The MOSFETs in turn are driven by a gate-driver IC. For FOC drive, a precise knowledge of the motor currents is mandatory and a main task of the electronics design.

Current sensing in external MOSFET bridges typically requires expensive and bulky sense resistors. Further, these have a high power dissipation, similar to the MOSFETs themselves. In-line current sensing is most universal and typically needs only two resistors per three-phase motor, but the required high-common mode range sense amplifiers are complex and expensive. Further, current continuously passes the resistors and in many cases doubles the output resistance of the circuit.

An alternative is magnetic field based current sensing. It has a low power dissipation, but also requires expensive sensors. Foot-point current sensing gives similar results to in-line sensing as long as the PWM scheme offers sufficiently long on-times of the low side for at least two of the three foot-points. This typically is the case with many PWM schemes. Foot-point sensing requires measurement in each foot-point, i.e. three high-current and high-power sense resistors. Single shunt footpoint measurement is an option used for cost-reduction, but it is complex and hard to handle, as it causes a number of restrictions and modifications to the PWM scheme in order to yield sufficient measuring time intervals for each phase.

There is a need for an inexpensive, reliable, and accurate method for current sensing in transistor-based motor control circuits.

### SUMMARY OF THE DISCLOSURE

According to a first aspect there is provided a method of determining a resistance of a first transistor in a drive system for operating a motor, the drive system comprising a plurality of transistors, and each transistor of the plurality of transistors comprising a control terminal, a first channel terminal, and a second channel terminal, the method comprising:
switching the plurality of transistors to operate the motor using an operating current, wherein current is configured to flow between the first and second channel terminals of each transistor in an on-state such that the operating current flows between motor coils of the motor and a reference node, and wherein the reference node is shared by each of the plurality of transistors;
applying a test current between the first and second channel terminals of the first transistor during the on-state of each of the plurality of transistors, wherein the test current applied at a current value;
measuring a voltage difference between the first and second channel terminals of the first transistor during the application of the test current;
determining the on-state resistance of the first transistor based on the current value and the measured voltage difference.

Optionally, further comprising applying the test current comprises applying the test current when each of the plurality of transistors are configured to simultaneously operate in their respective on-state.

Optionally, the method further comprises determining the motor current based on an applied voltage and the on-resistance of the first transistor.

Optionally, the operating current comprises a different amplitude from the test current.

Optionally, the test current is 5-20% the amplitude of the operating current.

Optionally, applying the test current comprises applying a first test current during a first time period, and the method further comprises: during the first time period and for a second transistor of the plurality of transistors, applying a respective first test current between the first and second channel terminals of the second transistor.

Optionally, the voltage difference between the first and second channel terminals of the first transistor is a first voltage difference. Optionally, applying the test current comprises applying a first test current during a first time period. Optionally, the method further comprising: during a second time period, measuring a second voltage difference between the first and second channel terminals of the first transistor. Optionally, the method further comprising: during a third time period, after the second time period, measuring a third voltage difference between the first and second channel terminals of the first transistor. Optionally, the method further comprising: determining the on-state resistance of the first transistor based on the current value and the measured first, second, and third voltage differences.

Optionally, the second time period is before the first time period, wherein the third time period is after the first time period.

Optionally, the second time period is after the first time period. Optionally, the method further comprises, during the third time period: applying a second test current between the first and second channel terminals of the first transistor during the on-state of each of the plurality of transistors; and, measuring the third voltage difference during the application of the second test current.

Optionally, the second test current is applied at the current value.

Optionally, the method further comprising, for a second transistor of the plurality of transistors: applying a third test current through the first and second channel terminals of the second transistor. Optionally, the method further comprising, for a second transistor of the plurality of transistors: measuring a fourth voltage difference between the first and second channel terminals of the second transistor during the application of the third test current. Optionally, the method further comprising, for a second transistor of the plurality of transistors: determining the on-state resistance of the second transistor based on the fourth voltage difference.

Optionally, applying the third test current comprises: applying the third test current during a different time period to the first test currents; or, applying the third test current during the first time period.

Optionally, the method further comprising, for the second transistor of the plurality of transistors: measuring a fifth voltage difference between the first and second channel terminals after applying the third test current between the first and second channel terminals.

Optionally, the method further comprising for the second transistor of the plurality of transistors: applying a fourth test current between the first and second channel terminals. Optionally, the method further comprising for the second transistor of the plurality of transistors: measuring a sixth voltage difference between the first and second channel terminals during the application of the fourth test current and after applying the third test current.

Optionally, applying the fourth test current comprises one of: applying the fourth test current during a different time period to the second test currents; or, applying the fourth test current during the third time period.

Optionally, measuring the fifth voltage difference comprises measuring the fifth voltage difference during the second time period.

Optionally, the method further comprises: during a first time period, before a second time period, measuring a first voltage difference between the first and second channel terminals of the first transistor, wherein the voltage difference over the channel terminals of the first transistor is a second voltage difference, wherein applying the test current comprises applying a first test current during the second time period. Optionally, the method further comprises: determining the on-state resistance of the first transistor based on the current value and the measured first and second voltage differences.

Optionally, the method further comprising, operating each of the plurality of transistors in the on-state continuously during the first and second time periods.

Optionally, the method further comprising, for a second transistor of the plurality of transistors: during the first time period, measuring a third voltage difference between the first and second channel terminals of the second transistor. Optionally, the method further comprising, for a second transistor of the plurality of transistors: during the second time period, measuring a fourth voltage difference between the first and second channel terminals of the second transistor. Optionally, determining the on-state resistance of the first transistor is further based on the measured third and fourth voltage differences.

Optionally, the method further comprising, for a third transistor of the plurality of transistors: during the first time period, measuring a fifth voltage difference between the first and second channel terminals of the third transistor. Optionally, the method further comprising, for a third transistor of the plurality of transistors: during the second time period, measuring a sixth voltage difference between the first and second channel terminals of the third transistor.

Optionally, determining the on-state resistance of the first transistor is further based on the measured fifth and sixth voltage differences.

Optionally, the method further comprising, for the first transistor of the plurality of transistors: during the third time period, measuring a fifth voltage difference between the first and second channel terminals of the first transistor. Optionally, the method further comprising, for the first transistor of the plurality of transistors: during the fourth time period, measuring a sixth voltage difference between the first and second channel terminals of the first transistor. Optionally, the method further comprising, for the first transistor of the plurality of transistors: during the third time period, measuring a seventh voltage difference between the first and second channel terminals of the second transistor. Optionally, the method further comprising, for the first transistor of the plurality of transistors: during the fourth time period: applying/injecting a second test current between the first and second channel terminals of the second transistor during the on-state of each of the plurality of transistors; and, measuring an eighth voltage difference between the first and second channel terminals of the second transistor. Optionally, determining the on-state resistance of the first transistor is further based on the measured fifth, sixth, seventh, and eighth voltage differences.

Optionally, the second test current applied at the current value.

An optional variant may use high-side RDSon, or calibrate and use both of them.

Optionally the test current is generated from a current source.

According to a second aspect there is provided a method of determining the motor current based on an applied voltage and an on-resistance of the first transistor, wherein the on-resistance of the first transistor is determined by the method of the first aspect.

According to a third aspect there is provided a method of operating a motor based on a motor current determined by the method of the second aspect.

According to a fourth aspect there is a driver circuit comprising:
a plurality of transistors arranged to drive a load, each transistor of the plurality of transistors comprising a control terminal, a first channel terminal, and a second channel terminal, wherein each transistor is arranged to be switched between an off-state and an on-state, wherein current is configured to flow between the channel terminals of each transistor in the on-state such that an operating current flows between motor coils of the motor and a reference node, wherein the reference node is shared by each of the plurality of transistors,
one or more processors configured to perform the method of the first aspect.

Optionally, the driver circuit further comprises a current source configured to generate the test current.

Optionally, the current source comprises a voltage source, a resistor, and a switching means. Optionally, the switching means is arranged to couple the voltage source to each transistor of the plurality of transistors.

### FIGURES

Figure 1a illustrates a schematic block wiring diagram of a driver circuit coupled to a motor.
Figure 1b illustrates a simplified representation of the block wiring diagram of the driver circuit coupled to the motor of Figure 1a.
Figure 2 illustrates a schematic block wiring diagram of a driver circuit coupled to a motor with additional optional features.
Figure 3 illustrates three graphs corresponding to the control signal of each transistor of Figure 2 and one graph corresponding to a test current in accordance with a first method of determining a resistance of a first transistor in a drive system.
Figure 4 illustrates a schematic block wiring diagram of a driver circuit configured to drive one phase of a motor with additional optional features.
Figure 5 illustrates three graphs corresponding to the control signal of each transistor of Figure 2 and one graph corresponding to a test current in accordance with a second method of determining a resistance of a first transistor in a drive system.
Figure 6 illustrates a graph representing the change in voltage between an initial time period and a second time period corresponding to one phase of the motor.
Figure 7 illustrates three graphs corresponding to the control signal of each transistor of Figure 2 and one graph corresponding to two test currents in accordance with a second method of determining a resistance of a first transistor in a drive system.
Figure 8a illustrates an additional schematic block wiring diagram of a driver circuit with optional features, coupled to a motor.
Figure 8b illustrates an additional schematic block wiring diagram of a driver circuit with optional features, coupled to a motor.
Figure 9 illustrates three graphs corresponding to the control signal of each transistor of Figure 8a or 8b and three graphs each corresponding to two respective test currents in accordance with a second method of determining a resistance of a first transistor in a drive system.
Figure 10 illustrates three graphs corresponding to the control signal of each transistor of Figure 8a or 8b and three graphs each corresponding to a respective test current in accordance with a third method of determining a resistance of a first transistor in a drive system.
Figure 11 illustrates a schematic block wiring diagram of a driver circuit coupled to one coil of a stepper motor.

### DETAILED DESCRIPTION

As a brief non-limiting overview of the invention, the present disclosure provides a method of determining a resistance of a transistor of a transistor-based driver circuit. With this resistance determined, a new method of current sensing/estimating in motor control circuits may be achieved which is advantageous in view of existing solutions. The method of determining a resistance of a transistor of a transistor-based driver circuit utilizes the on-state of the transistor during regular operation of a motor and applies an additional current (i.e., a test current) across the transistor to determine the on-state resistance of the transistor. Advantageously, this method may make use of current sense amplifiers as simple as those suitable for use with footpoint-shunt resistor amplifiers.

On-state resistance based current measurement has not been adopted previously because MOSFET on-state resistance is highly dependent on production stray and changes with MOSFET die temperature, especially in applications with high current. Therefore, quick recalibration of the on-state resistance measurement is required, as the temperature of the die can change within milliseconds. Thus, a problem overcome with the present disclosure is a method for calibration to compensate for MOSFET (or more generally, transistor) stray and the temperature dependence of resistance.

Advantageously, embodiments of the invention achieve an accurate and cost-effective solution: an extension circuit of the gate driver (e.g., realized in a HV-Power BCD technology) with means for on-state resistance calibration, with a corresponding algorithm. Power dissipation is low compared to a known sense-resistor based measurement, because in the moment of test current injection, terminal voltage is near zero (e.g. +- a few 100mV). Therefore, a low voltage source, (e.g., 3.3V, 5V), or the gate driver voltage (of typically 12V), can be used as source for test current generation.

In the following examples, a three-phase drive system with three connections (corresponding with phases u, v, and w) is described. However, it will be understood that the principles may apply to any number phased motor drive system. For example, stepper motors have four connections and are typically driven with two coils. It will be readily apparent to a skilled person how to translate the examples provided to other phased motors, including stepper motors. In addition, the principles may apply to any load driven by transistors operating in a scheme of switching (e.g., a PWM switching scheme).

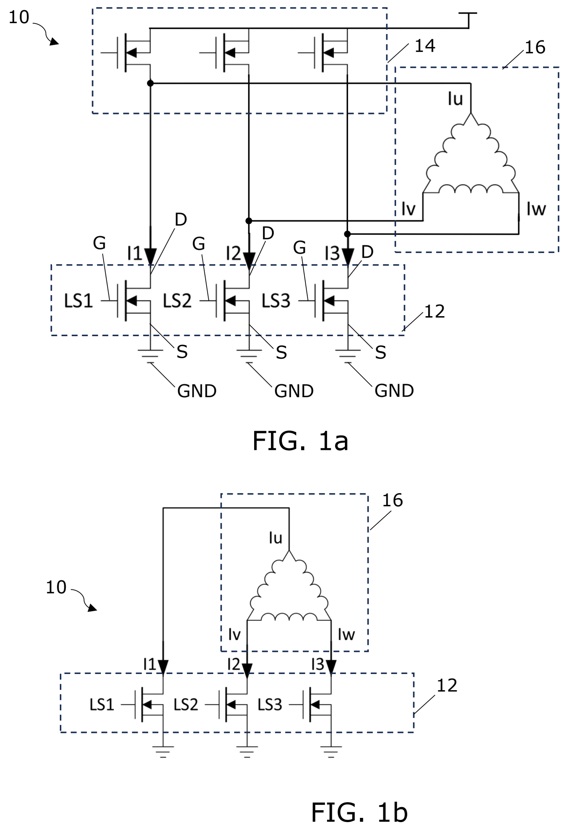

Figure 1a shows an example of a schematic block wiring diagram of a driver circuit 10 (such as a motor driver circuit) coupled to a motor 16 for carrying out the method in accordance with the invention. The driver circuit 10 comprises a first plurality of transistors 12, e.g., Low Side (LS) transistors, each corresponding to a phase of the motor 16, e.g., LS1 corresponds to a u-phase, LS2 corresponds to a v-phase, LS3 corresponds to a w-phase. The driver circuit 10 comprises a second plurality of transistors 14, e.g., High Side (HS) transistors, each corresponding to a phase of the motor 16. Each transistor of the driver circuit 10 comprises a control terminal (e.g., Gate, G), a first channel terminal (e.g., Drain, D), and a second channel terminal (e.g., Source, S). Each transistor of the driver circuit 10 is also arranged to be in an on-state or an off-state.

In operation, a controller switches the plurality of transistors to operate the motor 16 using an operating current. Current is configured to flow between the first and second channel terminals D, S of each transistor in an on-state such that the operating current flows between motor coils of the motor 16 and a reference node GND. The reference node GND is shared by the first plurality of transistors 12.

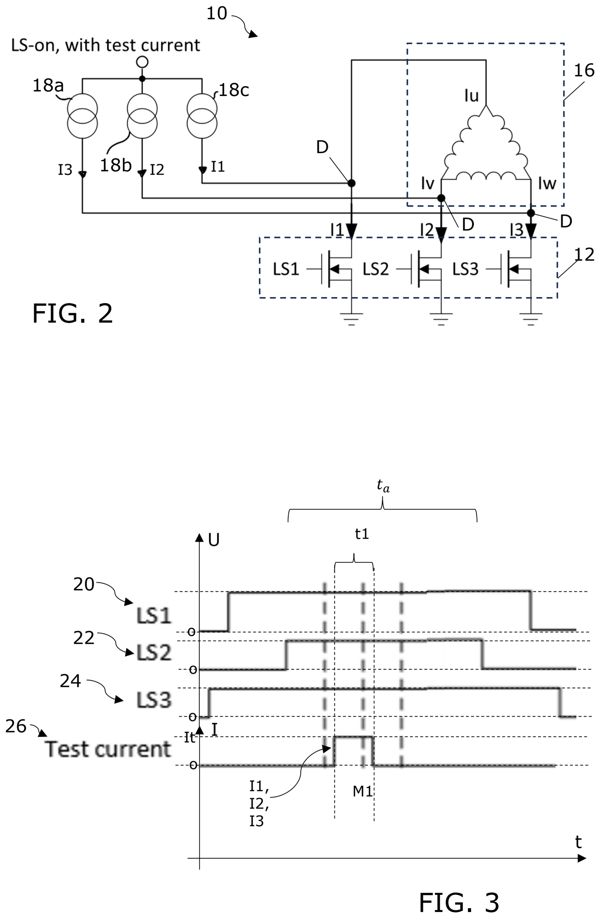

For purposes of explanation, only one of the first or second plurality of transistors 12, 14 are required. Figure 1b shows a simplified schematic block wiring diagram of a driver circuit 10 with only the first plurality of transistors 12 shown. However, it will be understood that the second plurality of transistors 14 are still present in the circuit, but not shown for simplicity. The second plurality of transistors 14 are also similarly omitted from the examples corresponding with Figures 2 to 10, however, it will be understood that the second plurality of transistors 14 are still present in these circuit, but not shown for simplicity. Alternatively, the second plurality of transistors 14 could have been shown and described, and the first plurality of transistor 12 could have been omitted for explanatory purposes.

Figure 2 shows a schematic block wiring diagram of the driver circuit 10 with additional optional features for carrying out the method in accordance with the invention. The driver circuit 10 may comprise controllable test current sources 18a, 18b, 18c corresponding to each phase of the motor 16. Each controllable test current source 18a, 18b, 18c is in electrical communication with a first channel terminal D of a corresponding one of the first plurality of transistors 12 (and also in electrical communication with a corresponding phase connection of the motor 16). In an alternative example, a single test current source may be provided in place of the three test current sources 18a, 18b, 18c. Each test current source is configured to generate a corresponding test current, i.e., a current pulse.

A first method of determining an on-state resistance of a first transistor in a drive system for operating a motor is described with reference to Figure 3.

Figure 3 shows graphs 20, 22, 24 corresponding to the control signal of each transistor LS1, LS2, LS3 of the first plurality of transistors 12. The graph 20 corresponds to a first transistor LS1 and shows part of a pulse width modulation (PWM) control signal such that during time period t1 the first transistor LS1 is in its on-state. The graph 22 corresponds to a second transistor LS2 and shows part of a PWM control signal such that during time period t1 the second transistor LS2 is in its on-state. The graph 24 corresponds to a third transistor LS3 and shows part of a PWM control signal such that during time period t1 the third transistor LS3 is in its on-state. The graph 26 shows the activation of three test currents I1, I2, I3 for the time period t1 to respective transistors LS1, LS2, LS3. Each test current I1, I2, I3 is a current pulse. The three test current I1, I2, I3 are applied when each of the first plurality of transistors 12 are configured to simultaneously operate in their respective on-state, i.e., during a period of time *tₐ*.

PWM schemes (e.g., for three-phase motor control) include times, where all of the first plurality of transistors 12 (i.e., all low-side switches) are in their respective on-state. These recirculation times may occur in low velocity motion, where effective PWM duty cycle is small, but may also repeatedly occur in generation of sine-shaped commutation control signals, e.g. when using a centred PWM scheme. Whenever such a period of time *tₐ* (when all of the first plurality of transistors are in their on-state) occurs, a determination (e.g., a calibration or recalibration) of one or more on-state resistances may be performed.

Graph 26 shows a test current I1 is applied between the first and second channel terminals of the first transistor LS1 during the on-state of each of the plurality of transistors 12. The test current I1 is a predetermined current value. The method includes making a voltage difference measurement M1 between the first and second channel terminals of the first transistor LS1 during the application of the test current I1. In some examples, a certain voltage drop over the first transistor LS1 is required to give sufficient signal amplitude for measurement. The operating current comprises a different amplitude from the test current I1. The test current I1 may be in a certain ratio to the typical operating current (optionally, a certain ratio of the peak application current). The predetermined current value may be 5-20% of the desired operating current, i.e. a 1A test current for a power stage typically operating at 10A (peak currents may be higher). For high current applications like 100A, a current source of 10A may be required. The time period t1 may at least cover the minimum required time to perform the voltage difference measurement M1 (e.g. 2µs).

The on-state resistance of the first transistor LS1 is based on: (a) the predetermined current value It; and, (b) the measured voltage difference between the first and second channel terminals D, S of the first transistor LS1 during the application of the test current I1.

As shown in Figure 3, applying the test current comprises applying a first test current I1 during a first time period t1. The first test current I1 is applied to the first transistor LS1 during the first time period t1. A second test current I2 is applied to the second transistor LS2 during the first time period t1. A third test current I3 is applied to the second transistor LS3 during the first time period t1. Respective test currents I1, I2, I3 are applied simultaneously between first and second channel terminals D, S of each transistor LS1, LS2, LS3 during the first period t1.

While all of the first plurality of transistors 12 are in their on-state, the sum of the three individual coil currents by principle is 0 (because the system is balanced). For example, with no test currents applied: I1+I2+I3=Iu+Iv+Iw=0.

Applying the first test current I1 to a reference node GND via one terminal (e.g., u-phase) (or optionally simultaneously applying test currents I1, I2, I3 to all terminals (e.g., u-phase, v-phase, w-phase)) of the motor 16 thus increases the sum of the currents seen in the first plurality of transistors 12 to the sum of the test currents. For example, with test currents applied: I1+I2+I3=(Iu+It)+(Iv+It)+(Iw+It)=3*It

Thus, the on-state resistance of each of the plurality of transistors 12 may be determined. Finally, the coil current of the motor 16 (call the motor current) may be determined based on the on-resistance of the first transistor LS1 and knowledge of the applied voltage (e.g., Vdd). As a result, the driver circuit 10 may be controlled to compensate for changes in the on-resistance of each of the first plurality of transistors 12. The on-resistance of a transistor may change with a change in temperature. This first method assumes that the on-resistance of each of the first plurality of transistors 12 varies identically, i.e. they experience the same temperature changes. This is a valid assumption at high-velocity motor operation. In an example, a single voltage difference measurement M1 per period of time *tₐ* is required to determine the on-resistance of a corresponding transistor LS1.

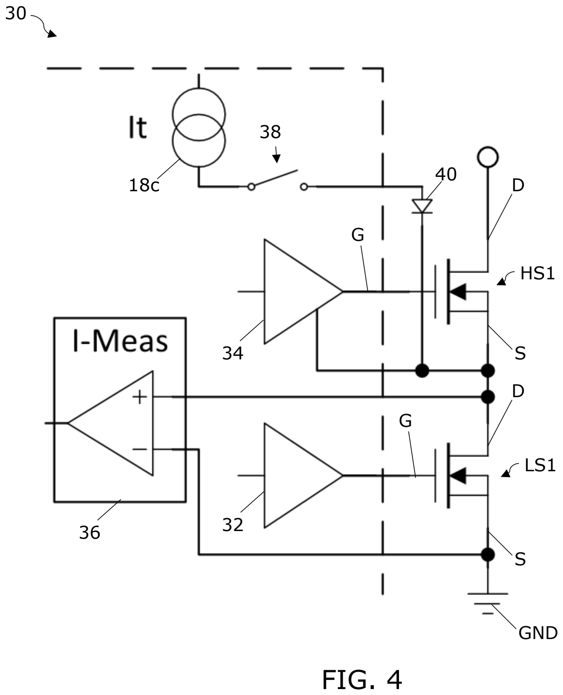

Figure 4 shows an example circuit 30 for performing a method described herein. Figure 4 only shows the components for one of the first plurality of transistors 12. However, it will be understood that a driver circuit 10 may comprise additional circuits similar to the circuit 30, each corresponding to one transistor of the first plurality of transistors 12.

Figure 4 shows the first transistor LS1 of the first plurality of transistors 12, and its corresponding first HS transistor HS1 of the second plurality of transistors 14. An optional first amplifier 32 is arranged to provide a control signal to the first transistor LS1 of the first plurality of transistors 12. An optional second amplifier 34 is arranged to provide a control signal to the first HS transistor HS1 of the second plurality of transistors 14.

A first test current source 18c is shown to be coupled (in electrical communication) to the first terminal D of the first transistor LS1 of the first plurality of transistors 12, via an optional switch 38, and an optional diode 40. The first test current source 18c is controllably coupled to the first terminal D of the first transistor LS1 of the first plurality of transistors 12, via the optional switch 38. The diode 40 may be present to prevent reverse conduction.

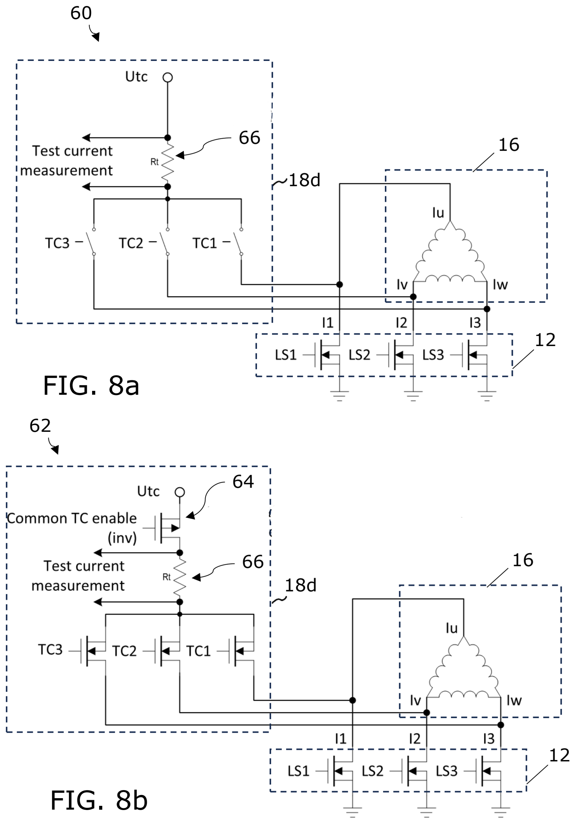

The first test current source 18c is configured to generate a corresponding test current at a predetermined current value, i.e., a current pulse. The first current source 18c may comprise a voltage source, a resistor, and a switching means 38. The switching means 38 is arranged to couple the voltage source to the first transistor LS1 of the first plurality of transistors 12. Alternatively, the first current source 18c may be coupled two or more switching means to couple the first current source 18c to each of the first plurality of transistors 12 (e.g., this is shown in Figures 8a and 8b).

A measurement component 36 is configured to receive a voltage difference between the first and second channel terminals of the first transistor LS1, and to generate a signal corresponding to the voltage difference between the first and second channel terminals of the first transistor LS1. The measurement component 36 may be a current sense amplifier, which may be as simple as those suitable for use with footpoint-shunt resistor amplifiers.

Figure 3 describes a simple way to determine the on-state resistance of at least the first transistor, by applying test currents I1, I2, I3 into the first plurality of transistors 12 and making a single measurement M1. However, two or more additional measurements M0, M2 per transistor may be made without applying a test current. Advantageously, when determining an on-state resistance of a transistor, an offset may be compensated for when making one or more additional measurements per transistor without applying a test current. Measuring with and without a test current provides a relative result.

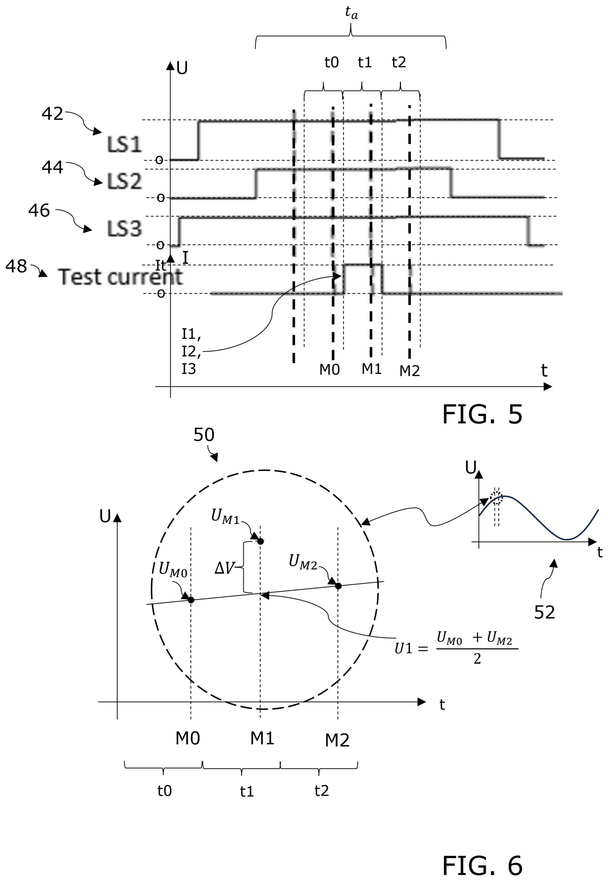

A second method of determining a resistance of a first transistor in a drive system for operating a motor is described with reference to Figures 5 to 7, and 9.

In very low velocity motion or in standstill, assuming that each of the first plurality of transistors 12 share the same temperature may not be realistic (e.g. for servo applications, where significant standstill torque is required). To compensate for this, additional features may be required. In examples, a PWM duty cycle may be lower because the motor does not have back EMF in standstill. Back-EMF is proportional to rotation velocity, and thus increased measurement time is available. This allows multiple current samples (e.g., M0, M1, M2) per a period of time *tₐ*, when all of the first plurality of transistors 12 are in their on-state.

Figure 5 shows graphs 42, 44, 46 corresponding to the control signal of each transistor LS1, LS2, LS3 of the first plurality of transistors 12. The graph 42 corresponds to transistor LS1 and shows part of a pulse width modulation (PWM) control signal such that during a first time period t1 the transistor LS1 is in its on-state. The graph 44 corresponds to transistor LS2 and shows part of a PWM control signal such that during the first time period t1 the transistor LS2 is in its on-state. The graph 46 corresponds to transistor LS3 and shows part of a PWM control signal such that during the first time period t1 the transistor LS3 is in its on-state. The graph 48 shows activation of three test currents I1, I2, I3 for the time period t1 to respective transistors LS1, LS2, LS3. Each test current I1, I2, I3 is a current pulse. The three test current I1, I2, I3 are applied when each of the first plurality of transistors 12 are configured to simultaneously operate in their respective on-state, i.e., during a period of time *tₐ.* That is, the first plurality of transistors 12 are each configured to operate in the on-state during an initial time period t0, the first time period t1, and a second time period t2.

Graph 48 shows a test current I1 is applied between the first and second channel terminals of the first transistor LS1 during the on-state of each of the plurality of transistors 12. The test current I1 may be the same as the test current I1 described with reference to the first method of determining a resistance of a first transistor in a drive system.

The first time period t1 may at least cover the minimum required time to perform the voltage difference measurement M1 (e.g. 2µs) and may be appended to the time required for a measurement M0, M2 without injection of the test current.

Individual on-state resistance measurements for each of the first plurality of transistors 12, can be determined based on doing three consecutive measurements M1, M2 and M3. Assuming a linear change of individual coil current for a short measurement interval, the individual phase current for I1, I2 or I3 at the time of measurement M1 is the mean value measured for M0 and M2. With this, the voltage difference measurement for all of the first plurality of transistors 12 may be determined with and without test current (shown for LS1). When measuring the voltage difference over the on-state resistance of the external power transistors (i.e., the first plurality of transistors 12), a relatively low voltage has to be measured, as power transistors are optimized for low resistance and thus low voltage drop. Measuring a low voltage may be prone to offset errors and can cause significant measurement error. The principles of the second method may eliminate this offset error because the measurement is differential, i.e. is measured with (e.g., M1) and without the current source (e.g., M0, M2), thus eliminating/reducing offset error as a source of error for determining the on-state resistance of the first transistor LS1.

Figure 6 shows a graph 50 representing the change in voltage between the initial time period t0 and the second time period t2 (inclusive) corresponding to the first transistor LS1. A graph 52 shows change in voltage corresponding to the u-phase of the motor (corresponding to the first transistor LS1) over a full cycle, to provide context relative (but not to scale) to the graph 50.

Turning to graph 50 of Figure 6, during an initial time period t0, an initial voltage difference measurement M0 is measured between the first and second channel terminals of the first transistor LS1. During a first time period t1, after the initial time period t0, a first voltage difference measurement M1 is measured between the first and second channel terminals of the first transistor LS1. During a second time period t2, after the first time period t1, a second voltage difference measurement M2 is measured between the first and second channel terminals of the first transistor LS1. The on-state resistance of the first transistor LS1 may be determined based on the predetermined current value It and the measured first, second, and third voltage differences *U*_{*M*0}, *U*_{*M*1}, *U*_{*M*2}. The initial time period t0 is before the first time period t1. The second time period t2 is after the first time period t1.

Three voltage difference measurements M0, M1, M2 are made while all of the first plurality of transistors are simultaneously in their on-state (i.e., during the period of time *tₐ*). The test current is applied during the first voltage difference measurement M1. Alternatively, the test current is applied during one or more of the voltage difference measurements M0, M1, M2.

Specifically, turning to the example of Figures 5 and 6, a first test current I1 is applied during a first time period t1. The first voltage difference measurement M1 is made while the first test current I1 is being applied. As a result, the voltage difference *U*_{*M*1} (relative to the reference voltage, e.g., GND) of the first voltage difference measurement M1 will be greater than the coil voltage U1 by an amount Δ*V* corresponding to the value of the first test current I1 and the resistance of the first transistor LS1. Second and third test currents I2, I3 (and associated measurements) corresponding to the second and third transistors LS2, LS3 may also be applied during the first time period t1, similarly to the example described above for the first transistor LS1. A comparison of the voltage difference measurements with test current (i.e., M1) and without test current M0, M2 during the same time period t0 to t2 enables a more accurate determination of the on-state resistance of a transistor LS1, LS2, LS3 of the first plurality of transistors 12.

The on-state resistance (*Ron*_{*LS*1}) of the first transistor LS1 can be determined based on the voltage difference measurements M0, M1, M2 and the value It of the test current I1 applied in accordance with equation (1) below: $Δ V = It ∗ {Ron}_{LS 1} = {U}_{M 1} - \left(\frac{{U}_{M 0} + {U}_{M 2}}{2}\right)$

Equation (1) assumes that the coil voltage changes linearly during the time period between t0 to t2 (e.g., as shown in Figure 6). This may be a valid assumption on short time scales, however, more accurate models/equations may be used to determine the on-state resistance (*Ron*_{*LS*1}) of the first transistor LS1. In an alternative example, to increase the accuracy of the determination of the on-state resistance (*Ron*_{*LS*1}) of the first transistor LS1, the first voltage difference measurement M1 can be skipped or weighted depending on the change between the initial and second voltage difference measurements M0 and M2. The change should be low compared to the value It of the test current I1, I2, I3 to ensure that the voltage difference measurements are not disturbed by an abrupt change of current, e.g., due to instable motor conditions. This calculation (e.g., equation (1)) is valid for the on-state resistance (*Ron*_{*LS*2}) of the second transistor LS2, and the on-state resistance (*Ron*_{*LS*3}) of the third transistor LS3.

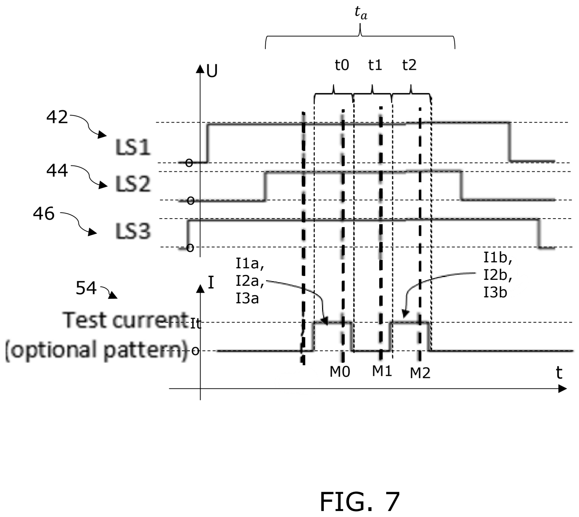

Figure 7 shows graphs 42, 44, 46 corresponding to the control signal of each transistor LS1, LS2, LS3 of the first plurality of transistors 12. The graphs 42, 44, 46 are the same as the graphs 42, 44, 46 of Figure 5 and will not be described again.

Figure 7 shows an alternative test current pattern graph 54 to the test current pattern graph 48 shown in Figure 5 (and used in Figure 6). The graph 54 shows a first and second test currents I1a, I1b applied between the first and second channel terminals of the first transistor LS1 during the on-state of each of the plurality of transistors 12, i.e., period of time *tₐ.* The test currents I1a, I1b may be the same as the test current I1 described with reference to the first method of determining a on-resistance of a first transistor in a drive system for operating a motor.

As shown in Figure 7, the first test current I1a is applied during the initial time period t0. The second test current I1b is applied during the second time period t2. The initial voltage difference measurement M0 is measured during the application of the first test current I1a. The first voltage difference measurement M1 is measured when no test current is applied. The second voltage difference measurement M2 is measured during the application of the second test current I1b. Since the measurements M0, M1, M2 for the first transistors 12 is known with and without test current (shown for LS1), the on-state resistance (*Ron*_{*LS*1}) of the first transistor LS1 can be determined based on the voltage difference measurements M0, M1, M2, and the value It of the first and second test currents I1a, I1b applied. The value of the first and second test currents I1a, I1b may be equal and the predetermined current value It.

This method may be repeated simultaneously for the other transistors LS2, LS3 of the first plurality of transistors 12 (i.e., all first test currents I1a, I2a, I3a are applied during the initial time period t0, and all second test currents I1b, I2b, I3b are applied during the second time period t2). Thus, the voltage difference measurements for the first plurality of transistors 12 may be determined with and without test current.

Figure 8a shows a schematic block wiring diagram of a driver circuit 60 with additional optional features for carrying out the method in accordance with the invention. The driver circuit 60 may comprise a single test current source 18d, with switch TC1, TC2, TC3 (e.g., transistors, MOSFETs) corresponding to each phase of the motor 16. The first terminal of each switch TC1, TC2, TC3 is coupled to the test current source 18d. The second terminal of each switch TC1, TC2, TC3 is in electrical communication with a first channel terminal D of a corresponding one of the first plurality of transistors 12 (and a phase connection of the motor 16). The switches TC1, TC2, TC3 are configured to be switched such that only a single of the switches TC1, TC2, TC3 is in an on-state (i.e., the first terminal is electrically coupled to its second terminal) at any one time.

The current source 18d is configured to generate a test current, i.e., a current pulse. The current source 18d comprises a voltage source Utc, a resistor 66, and three switches TC1, TC2, TC3, wherein each switch TC1, TC2, TC3 is arranged to couple the voltage source Utc to each transistor of the first plurality of transistors 12 via the resistor 66.

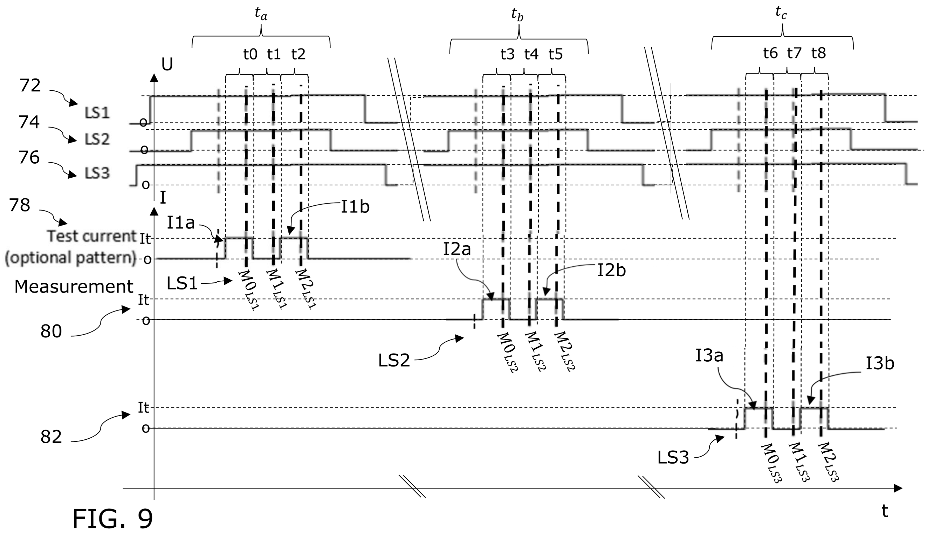

A single current source 18d is advantageous when high test currents are desired. In the example of Figure 9, the test current is applied to a single motor terminal (i.e., either the u-phase, v-phase, or w-phase) at a time using a single high current source 18d. The additional current can be assumed to flow at only a single motor terminal, as transistor resistance is typically very low. Thus, the voltage change at the transistor (e.g., LS1, LS2, LS3) when the test current is applied (and measurement time) is negligible when compared to motor coil impedance (e.g., Rcoil+RLcoil, which couples the three motor terminals u, v, w to each other). Measuring a low voltage may be prone to offset errors and can cause significant measurement error. Eliminating/reducing this offset error is especially important as the test current source is a fraction of the maximum motor current, and thus any offset error may result in a large error at higher current operation.

The schematic block wiring diagram of Figure 8a shows an optional way to simply generate a high test current to calibrate a higher power output stage using inexpensive discrete elements. This is advantageous for power stages, where the full integration of the test current generation into the gate driver is not feasible due to the demand of a test current beyond a few Amperes.

The schematic block wiring diagram 62 of Figure 8b shows another optional way to generate a high test current to calibrate a higher power output stage using inexpensive discrete elements. In the example of Figure 8b, the switches TC1, TC2, TC3 are NMOS transistors, to isolate the full supply voltage Utc while test current is off. Low power-rated (i.e., small, inexpensive) transistors capable of short-time conduction of the test current may be suitable, since (as described) they work with a very low duty cycle. The optional PMOS transistor 64 is configured to isolate the test current generator, when the NMOS body diodes of the transistors TC1, TC2, TC3 conduct. The voltage difference between the channel terminals of the reference resistor 66 may be measured to determine the current value It of the test current applied. The measured current value It may be used to more accurately determine the on-resistance of each of the first plurality of transistors 12. As conduction time of the additional components is short, low power devices (i.e., small, inexpensive transistors) may be selected.

At lower velocity, coil inductivity may provide filtering of a test current. A number of measurements may be taken over multiple periods of time when all of the first plurality of transistors 12 are in their on-state, e.g. the measurements may also be taken over different phases of a sine wave to eliminate any remaining effect of measurement disturbance by motor BEMF.

As described with reference to Figures 3 to 7, the test currents are applied through the first and second channel terminals of each transistor of the first plurality of transistors 12 simultaneously and within a period of time *tₐ*. The period of time *tₐ* comprises time periods t0 and t2. However, in a single current source example, only a single test current may be applied at a time.

As shown in Figure 9, test currents may be applied through the first and second channel terminals of one transistor of the first plurality of transistors 12 during a first, second, and third period of time *t_{a,} t_{b}, t_{c},* respectively. The first period of time *tₐ* comprises time periods t0, t1, t2. The second period of time *t_{b}* comprises time periods t3, t4, t5. The third period of time *t_{c}* comprises time periods t6, t7, t8. Each of the each of the first plurality of transistors 12 are configured to simultaneously operate in their respective on-state during the first, second and third periods of time *t_{a,} t_{b}, t_{c}.* Between each of the periods of time *tₐ,t_{b}, t_{c},* one or more of the first plurality of transistors 12 may switch between its respective off-state and on-state.

Figure 9 shows graphs 72, 74, 76 corresponding to the control signal of each transistor LS1, LS2, LS3 of the first plurality of transistors 12. The graph 72 corresponds to transistor LS1 and shows part of a pulse width modulation (PWM) control signal such that during the first, second, and third periods of time *tₐ,t_{b}, t_{c}* the transistor LS1 is in its on-state. The graph 74 corresponds to transistor LS2 and shows part of a PWM control signal such that during the first, second, and third periods of time *t_{a,} t_{b}, t_{c}* the transistor LS2 is in its on-state. The graph 76 corresponds to transistor LS3 and shows part of a PWM control signal such that during the first, second, and third periods of time *tₐ,t_{b}, t_{c}* the transistor LS3 is in its on-state.

The graph 78 shows the application of a first and second test current I1a, I1b for the initial time period t0 and the second time period t2, such that each test current I1a, I1b is a pulse. The first and second test currents I1a, I1b are applied through the first and second channel terminals of the first transistor LS1. Specifically, a first test current I1a is applied through the first and second channel terminals of the first transistor LS1, and a voltage difference measurement *M*0_{*LS*1} may be measured during the initial time period t0. A voltage difference measurement *M*1_{*LS*1} may be measured during the first time period t1. A second test current I1b is applied through the first and second channel terminals of the first transistor LS1, and a voltage difference measurement *M*2_{*LS*1} may be measured during the second time period t2.

The graph 80 shows the application of a third and fourth test current I2a, I2b for the third time period t3 and the fifth time period t5, such that each test current I2a, I2b is a pulse. The third and fourth test currents I2a, I2b are applied through the first and second channel terminals of the second transistor LS2. Specifically, a third test current I2a is applied through the first and second channel terminals of the second transistor LS2, and a voltage difference measurement *M*0_{*LS*2} may be measured during the third time period t3. A voltage difference measurement *M*1_{*LS*2} may be measured during the fourth time period t4. A fourth test current I2b is applied through the first and second channel terminals of the second transistor LS2, and a voltage difference measurement *M*2_{*LS*2} may be measured during the fifth time period t5.

The graph 82 shows the application of a sixth and eight test current I3a, I3b for the sixth time period t6 and the eighth time period t8, such that each test current I3a, I3b is a pulse. The sixth and eight test currents I3a, I3b are applied through the first and second channel terminals of the third transistor LS3. Specifically, a fifth test current (I3a) is applied through the first and second channel terminals of the third transistor LS3, and a voltage difference measurement *M*0_{*LS*3} may be measured during the sixth time period t6. A voltage difference measurement *M*1_{*LS*2} may be measured during the seventh time period t7. A sixth test current (I3b) is applied through the first and second channel terminals of the third transistor LS3, and a voltage difference measurement *M*2_{*LS*3} may be measured during the eighth time period t8.

The voltage difference measurements M0, M1, M2 for each transistor of the first plurality of transistors 12 may be found after a respective period of time *t_{a,} t_{b}, t_{c}.* The measurements made after the periods of time *t_{a,} t_{b}, t_{c}* of Figure 9 equate to the measurements made after the period of time *tₐ* of Figure 7. Therefore, the on-state resistance of each transistor LS1, LS2, LS3 of the first plurality of transistors 12 may be determined similarly to the method described with reference to Figure 7. Although, the test current pattern is shown to correspond to the test current pattern of Figure 7, the driver circuits 60, 62 of Figures 8a, 8b are also compatible with the test pattern and methodology described with reference to Figures 5 and 6 similarly.

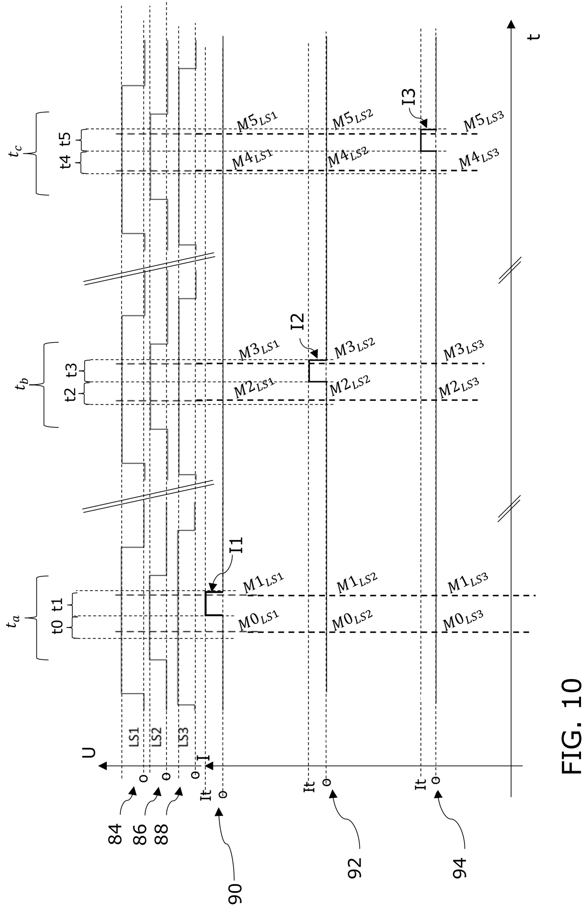

A third method of determining a resistance of a first transistor in a drive system for operating a motor is described with reference to Figure 10.

As shown in Figure 10, a test current I1, I2, I3 is applied into one motor input branch at a time, only. The driver circuits 10, 60, 62 of Figures 2, 4, 8a, or 8b may be used to implement the third method described with reference to Figure 10. The third method comprises measuring voltage differences between first and second channel terminals for all of the first plurality of transistors 12 simultaneously.

As shown in Figure 10, a respective test current may be applied through the first and second channel terminals of one transistor of the first plurality of transistors 12 during a first, second, and third period of time *t_{a,} t_{b}, t_{c}.* The first period of time *tₐ* comprises time periods t0, t1. The second period of time *t_{b}* comprises time periods t2, t3. The third period of time *t_{c}* comprises time periods t4, t5. Each of the each of the first plurality of transistors 12 are configured to simultaneously operate in their respective on-state during the first, second and third periods of time *t_{a,} t_{b}, t_{c}.* The value of each test current I1, I2, I3 is shown to be equal to a predetermined value It. In an alternative example, each test current may differ but still known (e.g., via measurement), and thus can be compensated for.

Figure 10 shows graphs 84, 86, 88 corresponding to the control signal of each transistor LS1, LS2, LS3 of the first plurality of transistors 12. The graph 84 corresponds to transistor LS1 and shows part of a pulse width modulation (PWM) control signal such that during the first, second, and third periods of time *t_{a,} t_{b}, t_{c}* the transistor LS1 is in its on-state. The graph 86 corresponds to transistor LS2 and shows part of a PWM control signal such that during the first, second, and third periods of time *tₐ,t_{b}, t_{c}* the transistor LS2 is in its on-state. The graph 88 corresponds to transistor LS3 and shows part of a PWM control signal such that during the first, second, and third periods of time *tₐ,t_{b}, t_{c}* the transistor LS3 is in its on-state.

The graph 90 shows the application of a first test current I1 for a first time period t1, such that the first test current I1 is a pulse. The first test current I1 is applied through the first and second channel terminals of the first transistor LS1. Specifically, a voltage difference measurement *M*0_{*LS*1}, *M*0_{*LS*2}, *M*0_{*LS*3} for each transistor LS1, LS2, LS3 may be measured during an initial time period t0. The first test current I1 is applied through the first and second channel terminals of the first transistor LS1, and a voltage difference measurement *M*1_{*LS*1}, *M*1_{*LS*2}, *M*1_{*LS*3} for each transistor LS1, LS2, LS3, may be measured during the first time period t1. Each of the first plurality of transistors 12 is operating in the on-state continuously during the initial and first time periods t0, t1.

The on-state resistance of the first transistor LS1 may be determined based on the current value It and the voltage differences measurements *M*0_{*LS*1}, *M*0_{*LS*2}, *M*0_{*LS*3}, *M*1_{*LS*1}, *M*1_{*LS*2}, *M*1_{*LS*3}, for all of the first plurality of transistors 12. A differential calculation for each voltage measurement allows offsets to be eliminated from the measurements. The on-state resistance *Ron*_{*LS*1} of the first transistor LS1 may be found from the equation (2): $\frac{{U}_{M {1}_{LS 1}} - {U}_{M {0}_{LS 1}}}{{Ron}_{LS 1}} = It - \frac{{U}_{M {1}_{LS 2}} - {U}_{M {0}_{LS 2}}}{{Ron}_{LS 2}} - \frac{{U}_{M {1}_{LS 3}} - {U}_{M {0}_{LS 3}}}{{Ron}_{LS 3}}$

An iterative method may be used to determine the on-state resistance *Ron*_{*LS*1} of the first transistor LS1. The accuracy of the determined on-state resistance *Ron*_{*LS*1} of the first transistor LS1 may improve over each iteration. Initially, the on-state resistance *Ron*_{*LS*2} of the second transistor LS2 may be assumed to be equal to the on-state resistance *Ron*_{*LS*3} of the third transistor LS3 and equal to zero. This is a valid approach, assuming that the main component determining the right side of the equation is the value It of the first test current I1, as the change in coil current (Iv and Iw) between both measurements M0, M1 should be negligible in comparison to It, with both measurements taken in a quick sequence. After some iterations for each on-state resistance *Ron*_{*LS*1}, *RonLS*₂, *Ron*_{*LS*3} of each of the first plurality of transistors 12, any error will be compensated for.

The graph 92 shows the application of a second test current I2 for a third time period t3, such that the second test current I2 is a pulse. The second test current I2 is applied through the first and second channel terminals of the second transistor LS2. Specifically, a voltage difference measurement *M*2_{*LS*1}, *M*2_{*LS*2}, *M*2_{*LS*3} for each transistor LS1, LS2, LS3, may be measured during a second time period t2. The second test current I2 is applied through the first and second channel terminals of the second transistor LS2, and a voltage difference measurement *M*3_{*LS*1}, *M*3_{*LS*2}, *M*3_{*LS*3} for each transistor LS1, LS2, LS3, may be measured during the third time period t3. Each of the first plurality of transistors 12 is operating in the on-state continuously during the second and third time periods t2, t3.

After the third time period, the on-state resistance *Ron*_{*LS*2} of the second transistor LS2 may be determined based on the determined on-state resistance *Ron*_{*LS*1} of the first transistor LS1, and the current value It and the voltage differences measurements *M*2_{*LS*1}, *M*2_{*LS*2}, *M*2_{*LS*3}, *M*3_{*LS*1}, *M*3_{*LS*2}, *M*3_{*LS*3} for all of the first plurality of transistors 12. The on-state resistance *Ron*_{*LS*2} of the second transistor LS2 may be found from the equation (3): $\frac{{U}_{M {3}_{LS 2}} - {U}_{M {2}_{LS 2}}}{{Ron}_{LS 2}} = It - \frac{{U}_{M {3}_{LS 1}} - {U}_{M {2}_{LS 1}}}{{Ron}_{LS 1}} - \frac{{U}_{M {3}_{LS 3}} - {U}_{M {2}_{LS 3}}}{{Ron}_{LS 3}}$

The on-state resistance *Ron*_{*LS*3} of the third transistor LS3 may be assumed to be equal to zero. With the iterative method, once the test current is applied again to the first transistor LS1, the on-state resistance *Ron*_{*LS*2} of the second transistor LS2 may be used in equation (2).

The graph 94 shows the application of a third test current I3 for a fifth time period t5, such that the third test current I3 is a pulse. The third test current I3 is applied through the first and second channel terminals of the third transistor LS3. Specifically, a voltage difference measurement *M*4_{*LS*1}, *M*4_{*LS*2}, *M*4_{*LS*3} for each transistor LS1, LS2, LS3, may be measured during a fourth time period t4. The third test current I3 is applied through the first and second channel terminals of the third transistor LS3, and a voltage difference measurement *M*5_{*LS*1}, *M*5_{*LS*2}, *M*5_{*LS*3} for each transistor LS1, LS2, LS3, may be measured during the fifth time period t5. Each of the first plurality of transistors 12 is operating in the on-state continuously during the fourth and fifth time periods t4, t5.

After the fifth time period, the on-state resistance *Ron*_{*LS*3} of the third transistor LS3 may be determined based on the determined on-state resistance *Ron*_{*LS*1} of the first transistor LS1, the determined on-state resistance *Ron*_{*LS*2} of the second transistor LS2, the current value It, and the voltage differences measurements *M*4_{*LS*1}, *M*4_{*LS*2}, *M*4_{*LS*3}, *M*5_{*LS*1}, *M*5_{*LS*2}, *M*5_{*LS*3} for all of the first plurality of transistors 12. The on-state resistance *Ron*_{*LS*3} of the third transistor LS3 may be found from the equation (4): $\frac{{U}_{M {5}_{LS 3}} - {U}_{M {4}_{LS 3}}}{{Ron}_{LS 3}} = It - \frac{{U}_{M {5}_{LS 1}} - {U}_{M {4}_{LS 1}}}{{Ron}_{LS 1}} - \frac{{U}_{M {5}_{LS 2}} - {U}_{M {4}_{LS 2}}}{{Ron}_{LS 2}}$

With the iterative method, once the test current is applied again to the first transistor LS1, the on-state resistance *Ron*_{*LS*2} of the second transistor LS2 and the on-state resistance *Ron*_{*LS*3} of the third transistor LS2 may be used in equation (2).

The voltage difference measurements *M*0_{*LS*1}, *M*0_{*LS*2}, *M*0_{*LS*3}, *M*1_{*LS*1}, *M*1_{*LS*2}, *M*1_{*LS*3}, *M*2_{*LS*1}, *M*2_{*LS*2}, *M*2_{*LS*3}, *M*3_{*LS*1}, *M*3_{*LS*2}, *M*3_{*LS*3}, *M*4_{*LS*1}, *M*4_{*LS*2}, *M*4_{*LS*3}, *M*5_{*LS*1}, *M*5_{*LS*2}, *M*5_{*LS*3} for each transistor of the first plurality of transistors 12 may be found after all periods of time *t_{a,} t_{b}, t_{c}.*

The example of Figure 10 is shown for a 3-phase motor. However, in a two-phase motor, or stepper motor, only two periods of time, e.g., *t_{a,} t_{b}* may be needed for the equations to be complete.

This third method described with reference to Figure 10 is advantageous over the second method as described with reference to Figure 9, because it requires two measurements M0, M1 per period *tₐ,t_{b},* and is resilient to non-linear changes of motor current between two measurement times.

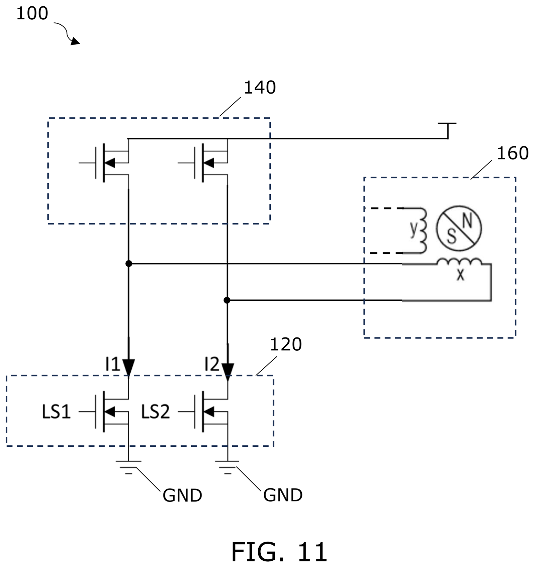

Figure 11 shows an example of a schematic block wiring diagram of a driver circuit 100 coupled to a stepper motor 160 for carrying out the methods described with reference to Figures 2 to 10. For example, each coil of the motor corresponds to a 2-phase control system, thus for each coil only two periods of time, e.g., *t_{a,} t_{b}* may be needed for the equations described to be complete, as would be understood by the skilled person. The driver circuit 100 comprises a first plurality of transistors 120, e.g., Low Side (LS) transistors, corresponding to a coil of the motor 160, e.g., LS1 and LS2 corresponding to an x-coil. The driver circuit 10 comprises a second plurality of transistors 140, e.g., High Side (HS) transistors, each corresponding to a LS transistor. Each transistor of the driver circuit 100 comprises a control terminal (e.g., Gate G), a first channel terminal (e.g., Drain D), and a second channel terminal (e.g., Source S). Each transistor of the driver circuit 100 is also arranged to be in an on-state or an off-state. For simplicity, the transistors corresponding to the y-coil of the stepper motor are not shown, but are present and arranged similarly to the transistors corresponding to the x-coil, as would be understood by the skilled person.

In an example, the transistor required for generation / switching of the test currents may be a low voltage (e.g., 5V) device.

In an example, external components may be used to isolate high voltage output potential, during conduction of the second plurality of transistors 14, from the current source.

Optionally, the complete current source and switching can be realized external to a driver integrated circuit (IC).

In an example, instead of having a precise current source as shown in Figures 2 and 4, a single precise resistor 66 can be used to inject the test current, as shown in Figures 8a, 8b. By measuring the actual voltage drop on the resistor, the test current can be determined individually for each measurement (e.g., M0, M1, M2).

In any example, the one or more time periods (e.g., t0, t1, t2, etc.) may be adjusted based on the relative value of the motor current. The one or more time periods (e.g., t1, t2, etc.) may be adjusted based on the change of the motor current within the previous time period (e.g., t0, t1, etc. respectively). This way, calibration duty cycle can be reduced further.

In an example, the driver circuit 10, 100 drives a load. The load may be a resistive load, an inductive load, or a motor. The driver circuit 10, 100 may be a motor drive circuit configured to drive a motor. The drive system may be a motor drive system.

In an alternative example, a scheme of switching the first plurality of transistors 12 (e.g., PWM scheme) may not offer sufficiently long on-times of the first plurality of transistors 12 for corresponding voltage difference measurements to take place. In this example, the scheme of switching may be overridden to generate sufficiently long on-times of the first plurality of transistors 12 for corresponding voltage difference measurements to take place, before transitioning back to the original scheme of switching.

In an example, the first plurality of transistors 12 and the second plurality of transistors are controlled by a first processor. The switches of the one or more current source (e.g., switch 38, TC1, TC2, TC3, common TC enable) of Figures 8a, 8b may be controlled by a second processor or the first processor. The first and/or second processor may be a logic circuit or other means to perform the one or more methods disclosed herein.

Although the examples are described with reference to LS transistors. In alternative examples, the methods herein may also be performed with reference to the HS transistors.

Each test current may be applied at a predetermined current value, or the current value may be determined via measurement (e.g., as shown in Figures 8a, 8b).

### General

Each block of the Figures is shown and defined for explanatory purposes only, it would be well understood that the algorithm or function which each block represents may be implemented in a plurality of other ways so long as the functionality as described is present. For example, blocks may be combined and implemented as part of a circuit arrangement, on a single integrated circuit, processor, or computer, or implemented by a plurality of circuit arrangements, integrated circuits, processors, and/or computers.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to."

The words "coupled" or "connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list. Moreover, in the following claims, the terms "initial", "first", "second", "third", "fourth", etc. are used merely as labels, and are not intended to impose numerical requirements on their objects. Methods examples described herein can be machine or computer-implemented at least in part.

It is to be understood that one or more features from one or more of the above- described embodiments may be combined with one or more features of one or more other ones of the above-described embodiments, so as to form further embodiments which are within the scope of the appended claims.

### NUMBERED CLAUSES

By way of non-limiting example, some aspects of the disclosure are set out in the following numbered clauses, with example reference numerals.

Clause 1. A method of determining a resistance of a first transistor in a drive system for operating a motor, the drive system comprising a plurality of transistors, and each transistor of the plurality of transistors comprising a control terminal, a first channel terminal, and a second channel terminal, the method comprising: switching the plurality of transistors to operate the motor using an operating current, wherein current is configured to flow between the first and second channel terminals of each transistor in an on-state such that the operating current flows between motor coils of the motor and a reference node, and wherein the reference node is shared by each of the plurality of transistors; applying a test current between the first and second channel terminals of the first transistor during the on-state of each of the plurality of transistors, wherein the test current applied at a current value; measuring a voltage difference (M1) between the first and second channel terminals of the first transistor during the application of the test current; and determining the on-state resistance of the first transistor based on the current value (It) and the measured voltage difference.

Clause 2. The method of clause 1, further comprising applying the test current comprises applying the test current when each of the plurality of transistors are configured to simultaneously operate in their respective on-state.

Clause 3. The method of clause 1 or 2, wherein the method further comprises determining the motor current based on an applied voltage and the on-resistance of the first transistor.

Clause 4. The method of any preceding clause, wherein the operating current comprises a different amplitude from the test current.

Clause 5. The method of clause 4, wherein the test current is 5-20% the amplitude of the operating current.

Clause 6. The method of any preceding clause, wherein applying the test current comprises applying a first test current (I1) during a first time period (t1), and the method further comprises: during the first time period (t1) and for a second transistor of the plurality of transistors, applying a respective first test current (I1) between the first and second channel terminals of the second transistor.

Clause 7. The method of any one of clauses 1 to 5, wherein the voltage difference (M1) between the first and second channel terminals of the first transistor is a first voltage difference, wherein applying the test current comprises applying a first test current (I1, I1a) during a first time period (t1), the method further comprising: during a second time period (t0, t2), measuring a second voltage difference (M0, M2) between the first and second channel terminals of the first transistor; during a third time period (t2, t3), after the second time period (t0, t2), measuring a third voltage difference (M2, M3) between the first and second channel terminals of the first transistor; and, determining the on-state resistance of the first transistor based on the current value (It) and the measured first, second, and third voltage differences.

Clause 8. The method of clause 7, wherein the second time period (t0) is before the first time period (t1), wherein the third time period (t2) is after the first time period (t1).

Clause 9. The method of clause 7, wherein the second time period (t2) is after the first time period (t1), the method further comprises, during the third time period (t3): applying a second test current (I1b) between the first and second channel terminals of the first transistor during the on-state of each of the plurality of transistors; and, measuring the third voltage difference (M3) during the application of the second test current (I1b).

Clause 10. The method of clause 9, wherein the second test current is applied at the current value.

Clause 11. The method of any one of clauses 7 to 10, the method further comprising, for a second transistor of the plurality of transistors: applying a third test current (I2, I2a) through the first and second channel terminals of the second transistor; measuring a fourth voltage difference (*M*1_{*LS*2}) between the first and second channel terminals of the second transistor during the application of the third test current (I2, I2a); and, determining the on-state resistance of the second transistor based on the fourth voltage difference (*M*1_{*LS*2}).

Clause 12. The method of clause 11, wherein applying the third test current (I2, I2a) comprises: applying the third test current during a different time period to the first test currents (I1, I1a); or, applying the third test current during the first time period (t1).

Clause 13. The method of any one of clauses 11 or 12, the method further comprising, for the second transistor of the plurality of transistors: measuring a fifth voltage difference (*M*2_{*LS*2}) between the first and second channel terminals after applying the third test current (I2, I2a) between the first and second channel terminals.

Clause 14. The method of clause 13, the method further comprising for the second transistor of the plurality of transistors: applying a fourth test current (I2b) between the first and second channel terminals; measuring a sixth voltage difference (*M*3_{*LS*2}) between the first and second channel terminals during the application of the fourth test current (I2b) and after applying the third test current (I2a).

Clause 15. The method of clause 14, wherein applying the fourth test current (I2b) comprises one of: applying the fourth test current during a different time period to the second test currents (I2a); or, applying the fourth test current (I2b) during the third time period (t3).

Clause 16. The method of any one of clauses 13 to 15, wherein measuring the fifth voltage difference (*M*2_{*LS*2}) comprises measuring the fifth voltage difference (*M*2_{*LS*2}) during the second time period (t2).

Clause 17. The method of any one of clauses 1 to 5, wherein the method further comprises: during a first time period (t0), before a second time period (t1), measuring a first voltage difference (*M*0_{*LS*1}) between the first and second channel terminals of the first transistor (LS1), wherein the voltage difference (*M*1_{*LS*1}) over the channel terminals of the first transistor is a second voltage difference (*M*1_{*LS*1}), wherein applying the test current comprises: applying a first test current (I1) during the second time period (t1); and determining the on-state resistance of the first transistor based on the current value (It) and the measured first and second voltage differences.

Clause 18. The method of clause 17, further comprising, operating each of the plurality of transistors in the on-state continuously during the first and second time periods (t1, t2).

Clause 19. The method of any one of clauses 17 or 18, the method further comprising, for a second transistor (LS2) of the plurality of transistors: during the first time period (t0), measuring a third voltage difference (*M*0_{*LS*2}) between the first and second channel terminals of the second transistor; during the second time period (t1), measuring a fourth voltage difference (*M*1_{*LS*2}) between the first and second channel terminals of the second transistor, wherein determining the on-state resistance of the first transistor is further based on the measured third and fourth voltage differences.

Clause 20. The method of clause 19, the method further comprising, for a third transistor (LS3) of the plurality of transistors: during the first time period (t0), measuring a fifth voltage difference (*M*0_{*LS*3}) between the first and second channel terminals of the third transistor; during the second time period (t1), measuring a sixth voltage difference (*M*1_{*LS*3}) between the first and second channel terminals of the third transistor, wherein determining the on-state resistance of the first transistor is further based on the measured fifth and sixth voltage differences.

Clause 21. The method of clause 19, the method further comprising, for the first transistor (LS1) of the plurality of transistors: during the third time period (t2), measuring a fifth voltage difference (*M*2_{*LS*1}) between the first and second channel terminals of the first transistor; during the fourth time period (t3), measuring a sixth voltage difference (*M*3_{*LS*1}) between the first and second channel terminals of the first transistor; during the third time period (t2), measuring a seventh voltage difference (*M*2_{*LS*2}) between the first and second channel terminals of the second transistor; during the fourth time period (t3): applying/injecting a second test current (I2) between the first and second channel terminals of the second transistor during the on-state of each of the plurality of transistors; and, measuring an eighth voltage difference (*M*3_{*LS*2}) between the first and second channel terminals of the second transistor, wherein determining the on-state resistance of the first transistor is further based on the measured fifth, sixth, seventh, and eighth voltage differences.

Clause 22. The method of clause 21, wherein the second test current (I2) applied at the current value.

Clause 23. A driver circuit comprising: a plurality of transistors arranged to drive a load, each transistor of the plurality of transistors comprising a control terminal, a first channel terminal, and a second channel terminal, wherein each transistor is arranged to be switched between an off-state and an on-state, wherein current is configured to flow between the channel terminals of each transistor in the on-state such that an operating current flows between motor coils of the motor and a reference node, wherein the reference node is shared by each of the plurality of transistors; and one or more processors configured to perform the method of any one of clauses 1 to 22.

Clause 24. The driver circuit of clause 23, further comprising a current source configured to generate the test current.

Clause 25. The driver circuit of clause 24, wherein the current source comprises a voltage source, a resistor, and a switching means, wherein the switching means is arranged to couple the voltage source to each transistor of the plurality of transistors.

## Claims

1. A method of determining a resistance of a first transistor in a drive system for operating a motor, the drive system comprising a plurality of transistors, and each transistor of the plurality of transistors comprising a control terminal, a first channel terminal, and a second channel terminal, the method comprising:
switching the plurality of transistors to operate the motor using an operating current, wherein current is configured to flow between the first and second channel terminals of each transistor in an on-state such that the operating current flows between motor coils of the motor and a reference node, and wherein the reference node is shared by each of the plurality of transistors;
applying a test current between the first and second channel terminals of the first transistor during the on-state of each of the plurality of transistors, wherein the test current applied at a current value;
measuring a voltage difference between the first and second channel terminals of the first transistor during the application of the test current; and
determining the on-state resistance of the first transistor based on the current value and the measured voltage difference.

2. The method of claim 1, further comprising applying the test current comprises applying the test current when each of the plurality of transistors are configured to simultaneously operate in their respective on-state.

3. The method of claim 1 or 2, wherein the method further comprises determining the motor current based on an applied voltage and the on-resistance of the first transistor.

4. The method of any preceding claim, wherein the operating current comprises a different amplitude from the test current, and optionally,
wherein the test current is 5-20% the amplitude of the operating current.

5. The method of any preceding claim, wherein applying the test current comprises applying a first test current during a first time period, and the method further comprises: during the first time period and for a second transistor of the plurality of transistors, applying a respective first test current between the first and second channel terminals of the second transistor.

6. The method of any one of claims 1 to 4, wherein the voltage difference between the first and second channel terminals of the first transistor is a first voltage difference, wherein applying the test current comprises applying a first test current during a first time period, the method further comprising:
during a second time period, measuring a second voltage difference between the first and second channel terminals of the first transistor;
during a third time period, after the second time period, measuring a third voltage difference between the first and second channel terminals of the first transistor; and,
determining the on-state resistance of the first transistor based on the current value and the measured first, second, and third voltage differences.

7. The method of claim 6, wherein one of:
the second time period is before the first time period, wherein the third time period is after the first time period; or,
the second time period is after the first time period, the method further comprises, during the third time period:
applying a second test current between the first and second channel terminals of the first transistor during the on-state of each of the plurality of transistors; and,
measuring the third voltage difference during the application of the second test current.

8. The method of any one of claims 6 or 7, the method further comprising, for a second transistor of the plurality of transistors:
applying a third test current through the first and second channel terminals of the second transistor;
measuring a fourth voltage difference between the first and second channel terminals of the second transistor during the application of the third test current; and,
determining the on-state resistance of the second transistor based on the fourth voltage difference, and optionally,
wherein applying the third test current comprises: applying the third test current during a different time period to the first test currents; or, applying the third test current during the first time period.

9. The method of claim 8, the method further comprising, for the second transistor of the plurality of transistors: measuring a fifth voltage difference between the first and second channel terminals after applying the third test current between the first and second channel terminals.

10. The method of claim 9, the method further comprising for the second transistor of the plurality of transistors:
applying a fourth test current between the first and second channel terminals; and
measuring a sixth voltage difference between the first and second channel terminals during the application of the fourth test current and after applying the third test current, and optionally,
wherein applying the fourth test current comprises one of: applying the fourth test current during a different time period to the second test currents; or, applying the fourth test current during the third time period.

11. The method of any one of claims 9 or 10, wherein measuring the fifth voltage difference comprises measuring the fifth voltage difference during the second time period.

12. The method of any one of claims 1 to 4, wherein the method further comprises:
during a first time period, before a second time period, measuring a first voltage difference between the first and second channel terminals of the first transistor, wherein the voltage difference over the channel terminals of the first transistor is a second voltage difference, wherein applying the test current comprises applying a first test current during the second time period; and
determining the on-state resistance of the first transistor based on the current value and the measured first and second voltage differences.

13. The method of claim 12, the method further comprising, for a second transistor of the plurality of transistors:
during the first time period, measuring a third voltage difference between the first and second channel terminals of the second transistor;
during the second time period, measuring a fourth voltage difference between the first and second channel terminals of the second transistor, wherein determining the on-state resistance of the first transistor is further based on the measured third and fourth voltage differences.

14. The method of claim 13, the method further comprising, one of:
for a third transistor of the plurality of transistors:
during the first time period, measuring a fifth voltage difference between the first and second channel terminals of the third transistor; and,
during the second time period, measuring a sixth voltage difference between the first and second channel terminals of the third transistor, wherein determining the on-state resistance of the first transistor is further based on the measured fifth and sixth voltage differences; or,
for the first transistor of the plurality of transistors:
during the third time period, measuring a fifth voltage difference between the first and second channel terminals of the first transistor;
during the fourth time period, measuring a sixth voltage difference between the first and second channel terminals of the first transistor;
during the third time period, measuring a seventh voltage difference between the first and second channel terminals of the second transistor;
during the fourth time period: applying/injecting a second test current between the first and second channel terminals of the second transistor during the on-state of each of the plurality of transistors; and,
measuring an eighth voltage difference between the first and second channel terminals of the second transistor, wherein determining the on-state resistance of the first transistor is further based on the measured fifth, sixth, seventh, and eighth voltage differences.

15. A driver circuit comprising:
a plurality of transistors arranged to drive a load, each transistor of the plurality of transistors comprising a control terminal, a first channel terminal, and a second channel terminal, wherein each transistor is arranged to be switched between an off-state and an on-state, wherein current is configured to flow between the channel terminals of each transistor in the on-state such that an operating current flows between motor coils of the motor and a reference node, wherein the reference node is shared by each of the plurality of transistors; and
one or more processors configured to perform the method of any one of claims 1 to 14.
